# EUROPÄISCHE PATENTSCHRIFT

(11) **EP 1 456 602 B1**
(45) Veröffentlichungstag und Bekanntmachung des Hinweises auf die Patenterteilung: **31.08.2005**
(21) Anmeldenummer: 02798277.6
(22) Anmeldetag: 13.12.2002
(51) Int. Cl.: G01B 11/00, H05K 13/08

(54) **SENSOR ZUR VISUELLEN POSITIONSERFASSUNG ( BAUELEMENT, SUBSTRAT ) MIT EINER MODULAREN BELEUCHTUNGSEINHEIT**
SENSOR FOR THE VISUAL POSITION DETECTION (COMPONENT, SUBSTRATE) COMPRISING A MODULAR LIGHTING DEVICE
CAPTEUR DE DETECTION VISUELLE DE POSITION (COMPOSANT, SUBSTRAT) DOTE D'UNE UNITE D'ECLAIRAGE MODULAIRE

(30) Priorität: 18.12.2001 DE 10162270
(43) Veröffentlichungstag der Anmeldung: 15.09.2004
(73) Patentinhaber: SIEMENS AKTIENGESELLSCHAFT, 80333 München (DE)
(72) Erfinder: MÜLLER, Werner, 83607 Holzkirchen (DE)
(86) Internationale Anmeldenummer: PCT/DE2002/004574
(87) Internationale Veröffentlichungsnummer: WO 2003/052346

(56) Entgegenhaltungen:
- EP-A- 0 634 892
- DE-U- 29 607 417
- JP-A- 8 219 716

## Beschreibung

Die Erfindung betrifft eine optische Sensorvorrichtung zur visuellen Erfassung von Objekten, insbesondere zur Positionserfassung und/oder zur Erkennung bzw. zur Überprüfung von Bauelementen und/oder Substraten.

Die automatische Bestückung von Substraten bzw. Leiterplatten mit Bauelementen erfolgt heutzutage üblicherweise mittels sog. Bestückautomaten. Dabei werden Bauelemente von einer Bauelementzuführeinrichtung mittels eines Bestückkopfes zu einer Aufsetzposition auf einer Leiterplatte transportiert. Unter dem Begriff Bauelemente werden im folgenden alle bestückfähigen Elemente verstanden, insbesondere elektronische Bauelemente, elektromechanische Bauelemente, Stecker und Steckverbindungen für elektrische und mechanische Kontakte sowie Abschirmbleche. Bestückfähige Elemente sind ferner beispielsweise Dies bzw. einzelne Teile eines Halbleiterwafers, welche insbesondere nach dem Strukturieren und dem Schneiden des Wafers zu fertigen Bauelementen weiterverarbeitet werden.

Aufgrund der insbesondere in den letzten Jahren zunehmenden Miniaturisierung von Bauelementen beruht ein korrekter Bestückvorgang auf einer präzisen Lagevermessung sowohl von dem zu bestückendem Bauelement als auch von der Leiterplatte, auf welcher das Bauelement aufgesetzt werden soll. Um außerdem die zusätzliche Anforderung einer hohen Bestückleistung zu erfüllen, muss der Bestückvorgang nicht nur genau, sondern zudem auch noch sehr schnell erfolgen. Dies kann nur mit einer optischen Erfassung der Bauelemente und/oder der Substrate erfüllt werden.

Eine derartige optische Erfassung ermöglicht beispielsweise die Erkennung von mechanisch defekten oder beschädigten Bauelementen, so dass die Fehlerwahrscheinlichkeit eines Bestückvorgangs erheblich reduziert werden kann. Ferner kann mittels einer optischen Erfassung die Lage eines zu bestükkenden Bauelements und/oder einer Leiterplatte genau festgestellt werden, so dass eine wichtige Vorraussetzung für eine hohe Genauigkeit des Bestückvorgangs erfüllt werden kann.

Für eine genaue Lageerkennung von Leiterplatten werden beispielsweise Markierungen verwendet, welche auf den Leiterplatten aufgebracht sind und welche von optischen Sensorvorrichtungen erfasst werden. Je nach Material der Leiterplatte dienen als Markierungen beispielsweise helle Markierungen auf einem relativ dunklen Hintergrund oder dunkle Markierungen auf einem relativ hellen Hintergrund.

Eine korrekte Erfassung von Bauelement und/oder Substrat erfordert allerdings auch eine Beleuchtung, welche hinsichtlich des Beleuchtungswinkels, d.h. des Winkels, unter dem das Beleuchtungslicht auf das zu erfassende Objekt auftrifft, und hinsichtlich der spektralen Verteilung des Beleuchtungslichtes an die jeweils zu erfassenden Objekte angepasst ist. Aus diesem Grund wurden Sensorvorrichtungen mit Beleuchtungssystemen entwickelt, welche für eine Vielzahl von verschiedenen Substraten und/oder Bauelementen eine für eine optische Erfassung der Objekte möglichst geeignete Beleuchtung schaffen.

So ist beispielsweise aus der US 5,469,294 ein Beleuchtungssystem bekannt, welches eine oder mehrere Lichtquellen, lichtundurchlässige Trennwände und Spiegel aufweist. Die Lichtquellen umfassen sowohl Leuchtdioden (LED's) als auch in einem breiten Spektralbereich emittierende Glühlampen. Dunkelfeldbeleuchtungen (die Beleuchtung erfolgt im wesentlichen parallel zur optischen Achse einer Kamera) und Hellfeldbeleuchtungen (die Beleuchtung erfolgt im wesentlichen senkrecht zur optischen Achse der Kamera) sind vorgesehen, um ein verbessertes Erkennen sowohl von hellen Objekten auf dunklem Hintergrund als auch von dunklen Objekten auf hellem Hintergrund zu erreichen.

Aus der WO 99/20093 ist eine Beleuchtungseinrichtung bekannt, welche mehrere Beleuchtungseinheiten aufweist, die jeweils Licht in einem zueinander unterschiedlichen Spektralbereich emittieren. Die Beleuchtungseinheiten können separat in ihrer Intensität variiert werden. Dadurch wird eine Beleuchtung mit variabler Spektralverteilung erzielt, durch die ein ausreichender Kontrast bei der Verwendung von unterschiedlichen Objekten bzw. Markierungen gegenüber verschieden hellen Hintergründen gewährleistet ist.

Oben genannte Beleuchtungssysteme haben den Nachteil, dass sie aufgrund ihrer Komplexität in der Herstellung teuer und in der Bedienung, d.h. in der Einstellung der jeweils erforderlichen Beleuchtung schwer zu handhaben sind. Ein weiterer Nachteil der oben genannten Beleuchtungsvorrichtungen besteht darin, dass sie nicht für alle Bauteile bzw. Leiterplatten geeignet sind. Somit muss bei der Verwendung von anderen Leiterplatten und/oder Bauelementen, für welche die Beleuchtungsvorrichtungen nicht geeignet sind, der Bestückautomat dahingehend umgebaut werden muss, dass eine an den speziellen Anwendungsfall angepasste Beleuchtung erreicht wird. Ein derartiger Umbau erfordert in der Regel eine neue Kalibrierung der Beleuchtungsvorrichtung und ist außerdem stets mit zusätzlichen Kosten und mit einer Standzeit des entsprechenden Bestückautomaten verbunden, so dass die integrale Bestückleistung einer Fertigungslinie reduziert wird.

Ferner ist aus der EP 0 634 892 A1 eine für Bildverarbeitungsvorgänge vorgesehene Beleuchtungsvorrichtung bekannt, weiche eine Mehrzahl von Leuchtdioden aufweist. Die Leuchtdioden sind an einem Beleuchtungsmodul angebracht, welches mittels einer Schraubverbindung lösbar an einem Kameramodul befestigt werden kann.

Der Erfindung liegt die Aufgabe zugrunde, eine optische Sensorvorrichtung zur visuellen Erfassung von Objekten zu schaffen, welche Sensorvorrichtung einfach zu handhaben und für eine Vielzahl von verschiedenen zu erfassenden Objekten geeignet ist.

Diese Aufgabe wird gelöst durch eine optische Sensorvorrichtung gemäß Anspruch 1.

Der Erfindung liegt die Erkenntnis zugrunde, dass mittels einer modular aufgebauten optischen Sensorvorrichtung für nahezu alle Applikationen, d.h. für nahezu alle Objekte, welche im Rahmen einer automatischen Bestückung von Leiterplatten mit Bauelementen für eine schnelle und präzise Bestückung erfasst werden, eine für die Erfassung notwendige passende Beleuchtung zur Verfügung gestellt werden kann.

Gemäß der Erfindung weist das optische Grundmodul eine zweite Beleuchtungseinheit auf. Die spektrale Verteilung und der Beleuchtungswinkel des von dieser zweiten Beleuchtungseinheit emittierten Lichts können derart ausgebildet sein, dass ein Großteil aller Applikationen, beispielsweise 80% aller in diesem Zusammenhang denkbaren Objekte, erfassbar sind. Das optisches Grundmodul kann ferner kostengünstig hergestellt werden und trägt somit zu einem geringen Grundpreis für Bestückautomaten, bei. Für den Fall, dass Objekte erfasst werden sollen, welche allein mit dem optischen Grundmodul nicht erfassbar sind, kann ein optisches Ergänzungsmodul verwendet werden, welches eine für die zu erfassenden Objekte und den jeweiligen Hintergrund spezielle Beleuchtung zur Verfügung stellt. So können beispielsweise verschiedene optische Ergänzungsmodule angeboten werden, die gemeinsam alle Spezialapplikatiönen abdecken. Auf diese Weise kann der Anwender eines Bestückautomaten die für seine spezielle Applikation erforderlichen optischen Ergänzungsmodule beim Hersteller der Sensorvorrichtuhg bzw. beim Hersteller des Bestückautomaten käuflich erwerben.

Die optischen Sensorvorrichtungen gemäß Anspruch 2 und Anspruch 3 haben den Vorteil, dass durch die Wahl von unterschiedlichen Beleuchtungswinkeln bzw. von unterschiedlichen Spektralverteilungen alle möglichen Kombinationen von zu erfassenden Objekten und Hintergründen, vor welchen die zu erfassenden Objekte angeordnet sind, mit einem für eine zuverlässige Erfassung der Objekte geeigneten Licht beleuchtet werden können. Es wird darauf hingewiesen, dass jede Beleuchtungseinheit, welche dem optischen Grundmodul oder dem optischen Ergänzungsmodul zugeordnet ist, Licht in mehreren unterschiedlichen Spektralbereichen emittieren kann.

Gemäß der Aesführungsform der Erfindung nach Anspruch 6 ist das optische Ergänzungsmodul an dem optischen Grundmodul mechanisch befestigbar. Dies hat den Vorteil, dass für die Anbringung des optischen Ergänzungsmodul keine eigene Befestigungsvorrichtung vorgesehen sein muss und dass ferner das optische Ergänzungsmodul stets in einer relativ zu dem optischen Grundmodul räumlich festen Lage angeordnet ist.

Gemäß der bevorzugten Weiterbildung der Erfindung nach Anspruch 8 ist das optische Ergänzungsmodul direkt oder indirekt über eine Schnittstelle mit dem optischen Grundmodul koppelbar. Diese Schnittstelle kann in vorteilhafter Weise derart ausgebildet sein, dass das optische Ergänzungsmodul über die Schnittstelle kontaktiert wird. Diese Kontaktierung kann der Stromversorgung der in dem optischen Ergänzungsmodul angeordneten Beleuchtungseinheiten dienen. Ein weiterer Vorteil der Kopplung zwischen dem optischen Grundmodul und dem optischen Ergänzungsmodul über eine Schnittstelle besteht darin, dass die Beleuchtungscharakteristik, d.h. der Beleuchtungswinkel und die spektrale Verteilung der Beleuchtung, zentral von einer Steuereinheit bestimmt werden kann, welche über die Schnittstelle sowohl mit dem optischen Grundmodul als auch mit dem optischen Ergänzungsmodul gekoppelt ist.

Gemäß Anspruch 9 ist die Schnittstelle zwischen optischem Grundmodul und optischem Ergänzungsmodul derart ausgebildet, dass das optische Ergänzungsmodul bzw. die Art der Beleuchtung durch das optische Ergänzungsmodul anhand von Daten identifiziert werden können, welche über die Schnittstelle übertragen werden. Somit kann, falls die Beleuchtungscharakteristik des optischen Ergänzungsmodul bekannt ist, eine Kalibrierung der optischen Sensorvorrichtung mittels der über die Schnittstelle übertragenen Daten automatisch erfolgen.

Weitere Vorteile und Merkmale der vorliegenden Erfindung ergeben sich aus der nachfolgenden beispielhaften Beschreibung derzeit bevorzugter Ausführungsformen. In der Zeichnung zeigen
- Figur 1: eine optische Sensorvorrichtung mit einem ersten optischen Ergänzungsmodul gemäß einem ersten Ausführungsbeispiel der Erfindung und
- Figur 2: eine optische Sensorvorrichtung mit einem zweiten optischen Ergänzungsmodul gemäß einem zweiten Ausführungsbeispiel der Erfindung.

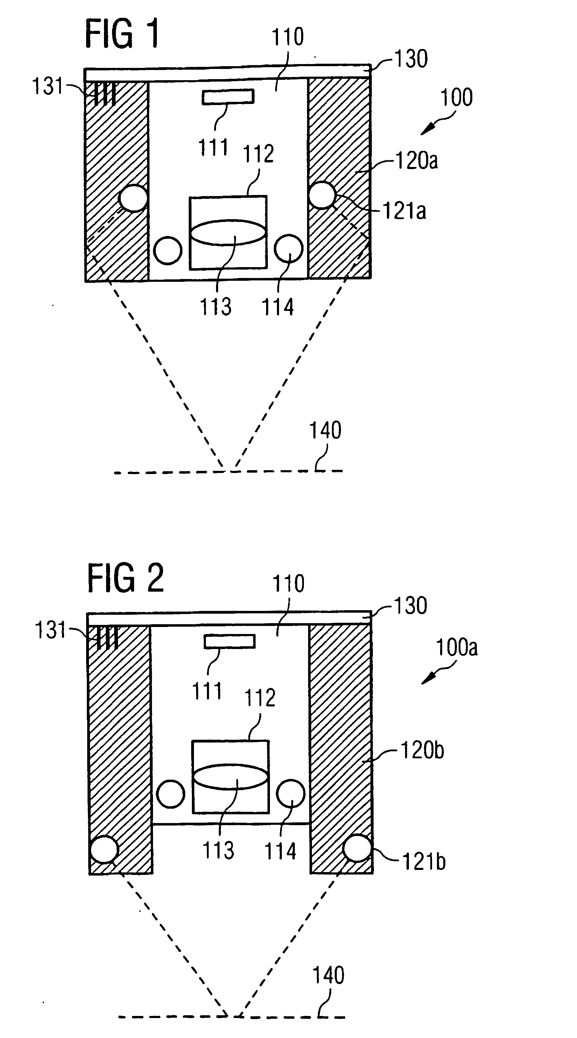

Figur 1 zeigt eine modular aufgebaute optische Sensorvorrichtung 100, welche ein optisches Grundmodul 110 und ein optisches Ergänzungsmodul 120a aufweist. Mittels der optischen Sensorvorrichtung 100 können Objekte erfasst werden, deren zu erfassende Oberfläche in der mit dem Bezugszeichen 140 bezeichneten Messebene liegen. Das optische Grundmodul 110 weist Beleuchtungselemente 114, eine Abbildungsoptik 112, welche beispielsweise eine Linse 113 umfasst und eine CCD-Kamera 111 auf. Die Abbildungsoptik 112 bildet das zu erfassende Objekt (nicht dargestellt) auf die CCD-Kamera 111 ab. Es wird darauf hingewiesen, dass die Abbildungsoptik 112 in Figur 1 nur schematisch dargestellt ist und auch mehrere optische Elemente wie beispielsweise andere Linsen, Strahlteiler und/oder Spiegel enthalten kann. Ebenso wird darauf hingewiesen, dass das optische Grundmodul neben den Beleuchtungselementen 114 auch weitere Beleuchtungselemente aufweisen kann, welche direkt oder indirekt das in der Messebene 140 angeordnete Objekt (nicht dargestellt) beleuchten.

Das optische Ergänzungsmodul 120a weist Beleuchtungselemente 121a auf, welche gemäß dem hier dargestellten Ausführungsbeispiel der Erfindung das in der Messebene 140 angeordnete Objekt (nicht dargestellt) unter einem anderen Winkel als die Beleuchtungselemente 114 beleuchten. Das von den Beleuchtungselementen 121a emittierte Licht weist ferner eine andere spektrale Verteilung als das Licht auf, welches von den Beleuchtungselementen 114 des optischen Grundmoduls 110 emittiert wird. An dieser Stelle wird ebenso darauf hingewiesen, dass das optische Ergänzungsmodul 120a in Figur 1 nur schematisch dargestellt ist und weitere optische Komponenten, wie beispielsweise zusätzliche Beleuchtungselemente, Abbildungsoptiken, Strahlteiler und/oder Spiegel enthalten kann. Gemäß dem hier dargestellten Ausführungsbeispiel wird das optische Ergänzungsmodul 120a auf das optische Grundmodul 110 aufgesteckt. Beim Aufstecken des optischen Ergänzungsmoduls 120a wird über eine Schnittstelle 131 eine Kontaktierung zwischen dem optischen Grundmodul 110 und dem optischen Ergänzungsmodul 120a hergestellt. Diese Schnittstelle befindet sich gemäß dem hier dargestellten Ausführungsbeispiel auf einer Grundplatte 130, an welcher sowohl das optische Grundmodul 110 als auch das optische Ergänzungsmodul 120a befestigbar ist.

Über die Schnittstelle 131 können gemäß dem hier dargestellten Ausführungsbeispiel der Erfindung Daten übertragen werden, welche für die Art des optischen Ergänzungsmoduls 120a bzw. für die Art der Beleuchtung charakteristisch sind, welche durch das optische Ergänzungsmodul 120a bereitgestellt wird. Somit kann die Beleuchtung sowohl mittels des optischen Grundmoduls 110 als auch mittels des optischen Ergänzungsmodul 120a über eine nicht dargestellte zentrale Steuereinheit bestimmt werden und so die für die jeweilige Applikation optimale Beleuchtung sowohl hinsichtlich spektraler Verteilung als auch hinsichtlicht der Winkelverteilung generiert werden.

In Figur 2 ist eine optische Sensorvorrichtung 100a dargestellt, welche sich gegenüber der in Figur 1 dargestellten optischen Sensorvorrichtung 100 durch ein anderes optisches Ergänzungsmodul 120b unterscheidet, welches ebenfalls auf das optische Grundmodul 110 aufgesteckt ist. Soweit die Bezugszeichen von Figur 2 mit denen von Figur 1 übereinstimmen, beziehen sie sich jeweils auf Einzelkomponenten, welche sowohl in der Sensorvorrichtung 100a als auch in der Sensorvorrichtung 100 identisch vorhanden sind.

Das optische Ergänzungsmodul 120b weist Beleuchtungselemente 121b auf, welche ein in der Messebene 140 angeordnetes Objekt (nicht dargestellt) beleuchten. Dabei unterscheidet sich die Beleuchtung, welche von dem optischen Ergänzungsmodul 120b erzeugt wird, gegenüber der Beleuchtung durch das optische Ergänzungsmodul 120a durch einen anderen Beleuchtungswinkel, durch eine andere spektrale Verteilung der Beleuchtung und durch einen anderen Abstand zwischen den Beleuchtungselementen 121a und dem zu erfassenden Objekt.

Es wird darauf hingewiesen, dass das optische Ergänzungsmodul 120b in Figur 2 nur schematisch dargestellt ist und außer den Beleuchtungselementen 121b zusätzlich weitere Beleuchtungselemente, Abbildungsoptiken, Strahlteiler oder Spiegel aufweisen kann.

Zusammenfassend schafft die Erfindung eine modular aufgebaute optische Sensorvorrichtung 100 mit einem optisches Grundmodul 110 und einem Ergänzungsmodul 120a. Das optische Ergänzungsmodul 120a kann an dem optischen Grundmodul angeordnet werden und durch andere optische Ergänzungsmodule 120b ausgetauscht werden. Die optischen Ergänzungsmodule 120a, 120b zeichnen sich durch unterschiedliche Beleuchtungscharakteristiken aus. Auf diese Weise kann je nach Art des zu erfassenden Objekts ein hinsichtlich des Beleuchtungswinkels und der spektralen Verteilung des Beleuchtungslichtes geeignetes Ergänzungsmodul 120a, 120b ausgewählt werden. Gemäß einem Ausführungsbeispiel der Erfindung ist das optische Grundmodul 110 mit dem optischen Ergänzungsmodul 120a, 120b über eine Schnittstelle 131 gekoppelt, so dass das jeweils verwendete optische Ergänzungsmodul 120a, 120b von einer zentralen Steuereinheit identifiziert werden kann und somit bei einem Wechsel des optischen Ergänzungsmoduls 120a, 120b eine Kalibrierung der optischen Sensorvorrichtung 100 nicht mehr erforderlich ist.

## Patentansprüche

1. Optische Sensorvorrichtung zur visuellen Erfassung von Objekten, insbesondere zur Positionsbestimmung und/oder zur Erkennung bzw. Überprüfung von Bauelementen und/oder Substraten, mit
• einem Lichtdetektor (111),
• einer Abbildungsoptik (113), welche ein Messfeld (140) eines zu erfassenden Objekts auf den Lichtdetektor (111) abbildet,
• einem ersten Beleuchtungselement (121a, 121b), welches das Messfeld (140) beleuchtet, und
• einem zweiten Beleuchtungselement (114), welches das Messfeld (140) beleuchtet,
wobei
- der Lichtdetektor (111), die Abbildungsoptik (113) und das zweite Beleuchtungselement (114) in einem optischen Grundmodul (110) angeordnet sind,
- das erste Beleuchtungselement (121a, 121b) in einem optischen Ergänzungsmodul (120a, 120b) angeordnet ist und
- das optische Ergänzungsmodul (120a, 120b) an dem optischen Grundmodul (110) reversibel anbringbar ist.

2. Optische Sensorvorrichtung gemäß Anspruch 1, bei der das erste Beleuchtungselement (121a, 121b) und das zweite Beleuchtungselement (114) derart ausgebildet sind, dass das zu erfassende Objekt von dem zweiten Beleuchtungselement (114) unter einem anderen Winkel als von dem ersten Beleuchtungselement (121a, 121b) beleuchtet wird.

3. Optische Sensorvorrichtung gemäß einem der Ansprüche 1 bis 2, bei der das erste Beleuchtungselement (121a, 121b) Licht in einem ersten Spektralbereich und das zweite Beleuchtungselement (114) Licht in einem zweiten Spektralbereich emittiert.

4. Optische Sensorvorrichtung gemäß einem der Ansprüche 1 bis 3, bei der das erste Beleuchtungselement (121a, 121b) und/oder das zweite Beleuchtungselement (114) zumindest eine Leuchtdiode aufweisen.

5. Optische Sensorvorrichtung gemäß einem der Ansprüche 1 bis 4, bei der der Lichtdetektor eine CCD-Kamera (111) ist.

6. Optische Sensorvorrichtung gemäß einem der Ansprüche 1 bis 5, bei der das optische Ergänzungsmodul (120a, 120b) an dem optischen Grundmodul (110) mechanisch befestigbar ist.

7. Optische Sensorvorrichtung gemäß Anspruch 6, bei der das optische Ergänzungsmodul (120a, 120b) an dem optischen Grundmodul (110) aufsteckbar ist.

8. Optische Sensorvorrichtung gemäß einem der Ansprüche 1 bis 7, bei der das optische Ergänzungsmodul (120a, 120b) direkt oder indirekt über eine Schnittstelle (131) mit dem optischen Grundmodul (110) koppelbar ist.

9. Optische Sensorvorrichtung gemäß Anspruch 8, bei der die Schnittstelle (131) derart ausgebildet ist, dass über die Schnittstelle (131) Daten übertragbar sind, welche für das optische Ergänzungsmodul (120a, 120b) und/oder für die Art der Beleuchtung durch das optische Ergänzungsmodul (120a, 120b) charakteristisch sind.

## Claims

1. Optical sensor device for visually detecting objects, in particular for detecting the position of components and/or substrates and/or for identifying or, as the case may be, checking components and/or substrates, having
• a light detector (111),
• an optical imaging system (113) which images a measuring field (140) of an object requiring to be detected onto the light detector (111),
• a first illuminating element (121a, 121b) which illuminates the measuring field (140) and
• a second illuminating element (114) which illuminates the measuring field (140),
wherein
- the light detector (111), the optical imaging system (113) and the second illuminating element (114) are located in a basic optical module (110),
- the first illuminating element (121a, 121b) is located in a supplementary optical module (120a, 120b) and
- the supplementary optical module (120a, 120b) can be reversibly attached to the basic optical module (110).

2. Optical sensor device according to claim 1 wherein the first illuminating element (121a, 121b) and the second illuminating element (114) are embodied in such a way that the object requiring to be detected is illuminated by the second illuminating element (114) at an angle different from that of the first illuminating element (121a, 121b).

3. Optical sensor device according to one of claims 1 to 2 wherein the first illuminating element (121a, 121b) emits light in a first spectral range and the second illuminating element (114) emits light in a second spectral range.

4. Optical sensor device according to one of claims 1 to 3 wherein the first illuminating element (121a, 121b) and/or the second illuminating element (114) have at least one light-emitting diode.

5. Optical sensor device according to one of claims 1 to 4 wherein the light detector is a CCD camera (111).

6. Optical sensor device according to one of claims 1 to 5 wherein the supplementary optical module (120a, 120b) can be mechanically secured to the basic optical module (110).

7. Optical sensor device according to claim 6 wherein the supplementary optical module (120a, 120b) can be plugged onto the basic optical module (110).

8. Optical sensor device according to one of claims 1 to 7 wherein the supplementary optical module (120a, 120b) can be coupled directly or indirectly to the basic optical module (110) via an interface (131).

9. Optical sensor device according to claim 8 wherein the interface (131) is embodied in such a way that data which is characteristic of the supplementary optical module (120a, 120b) and/or of the type of the illumination by the supplementary optical module (120a, 120b) can be transmitted over the interface (131).

## Revendications

1. Dispositif de détection optique en vue de la direction visuelle d'objets et en particulier pour la détermination de la position et/ou la reconnaissance resp. la vérification de composants et/ou de supports, qui présente :
• un détecteur de lumière (111),
• une optique d'imagerie (113) qui forme sur le détecteur de lumière (111) une zone de mesure (140) d'un objet à détecter,
• un premier élément d'éclairage (121a, 121b) qui éclaire la zone de mesure (140) et
• un deuxième élément d'éclairage (114) qui éclaire la zone de mesure (140),
dans lequel
- le détecteur de lumière (111), l'optique d'imagerie (113) et le deuxième élément d'éclairage (114) sont disposés dans un module optique de base (110),
- le premier élément d'éclairage (121a, 121b) est disposé dans un module optique complémentaire (120a, 120b) et
- le module optique complémentaire (120a, 120b) peut être installé de manière réversible sur le module optique de base (110).

2. Dispositif de détection optique selon la revendication 1, dans lequel le premier élément d'éclairage (121a, 121b) et le deuxième élément (114) sont configurés de telle sorte que l'objet à détecter est éclairé par le deuxième élément d'éclairage (114) sous un autre angle que par le premier élément d'éclairage (121a, 121b).

3. Dispositif de détection optique selon l'une des revendications 1 à 2, dans lequel le premier élément d'éclairage (121a, 121b) émet de la lumière dans une première plage spectrale et le deuxième élément (114) émet de la lumière dans une deuxième plage spectrale.

4. Dispositif de détection optique selon l'une des revendications 1 à 3, dans lequel le premier élément d'éclairage (121a, 121b) et/ou le deuxième élément (114) présentent au moins une diode luminescente.

5. Dispositif optique d'éclairage selon l'une des revendications 1 à 4, dans lequel le détecteur de lumière est une caméra CCD (111).

6. Dispositif de détection optique selon l'une des revendications 1 à 5, dans lequel le module optique complémentaire (120a, 120b) peut être fixé mécaniquement sur le module optique de base (110).

7. Dispositif de détection optique selon la revendication 6, dans lequel le module optique complémentaire (120a, 120b) peut être enfiché sur le module optique de base (110).

8. Dispositif de détection optique selon l'une des revendications 1 à 7, dans lequel le module optique complémentaire (120a, 120b) peut être accouplé au module optique de base (110) directement ou indirectement par l'intermédiaire d'une interface (131).

9. Dispositif de détection optique selon la revendication 8, dans lequel l'interface (131) est configurée de telle sorte que des données qui sont caractéristiques du module optique complémentaire (120a, 120b) et/ou du type d'éclairage délivré par le module optique complémentaire (120a, 120b) peuvent être transmises par l'interface (131).
